# EUROPÄISCHE PATENTSCHRIFT

(11) **EP 2 931 502 B1**
(45) Veröffentlichungstag und Bekanntmachung des Hinweises auf die Patenterteilung: **15.06.2016**
(21) Anmeldenummer: 12816464.7
(22) Anmeldetag: 11.12.2012
(51) Int. Cl.: B29D 11/00, G02B 3/00, H01L 27/146

(54) **VERFAHREN ZUM HERSTELLEN EINES LINSENWAFERS**
METHOD FOR PRODUCING A LENS WAFER
PROCÉDÉ DE FABRICATION D'UNE PLAQUETTE DE LENTILLES

(43) Veröffentlichungstag der Anmeldung: 21.10.2015
(73) Patentinhaber: Ev Group E. Thallner GmbH, 4782 St. Florian am Inn (AT)
(72) Erfinder: KAST, Michael, A-4600 Wels (AT)
(74) Vertreter: Schweiger, Johannes
(86) Internationale Anmeldenummer: PCT/EP2012/075015
(87) Internationale Veröffentlichungsnummer: WO 2014/090281

(56) Entgegenhaltungen:
- EP-A1- 2 639 033
- WO-A1-2012/063882
- US-A- 5 690 973

## Beschreibung

Die vorliegende Erfindung betrifft ein Verfahren zum Herstellen, insbesondere Prägen, eines, eine Vielzahl von Mikrolinsen aufweisenden, Linsenwafers gemäß den Anspruch 1.

Mikrolinsen finden in erster Linie Anwendung für Geräte, die eine optische Fokussiereinrichtung benötigen, wie beispielsweise Kameras von Mobiltelefonen. Auf Grund des Miniaturisierungsdrucks sollen die funktionalen Bereiche immer kleiner werden. Je weiter die Mikrolinsen miniaturisiert werden sollen, desto schwieriger wird deren optisch korrekte Herstellung, weil gleichzeitig ein enormer Kostendruck für die idealerweise in Massenfertigung herzustellenden Mikrolinsen besteht.

Die Druckschrift WO 2012/063882 A1 zeigt ein Verfahren zur Herstellung von Linsen.

Die optischen Systeme können aus statischen und/oder dynamischen konvexen oder konkaven Linsen bestehen. Die Mikrolinsen werden entweder einzeln auf oder in einem entsprechenden Trägersubstrat geprägt oder sind Teil eines monolithischen Wafers. Diese monolithischen Wafer stellen also trägerlose Linsenfelder dar. Trägerlos bedeutet in diesem Zusammenhang, dass die Linsen nicht auf einem eigenen Träger geformt werden müssen. Das Linsenmaterial wird vielmehr entlang einer entsprechenden Fläche durch einen oberen und/oder unteren Stempel zu einem Linsenfeld verformt, welches sich selbst trägt. Die fortschreitende Miniaturisierung wird durch die Verwendung von solchen trägerlosen Linsenfeldern beschleunigt. Trägerlose Linsenfelder bieten einerseits eine größere Flexibilität beim optischen Design von dünneren Linsen sowie andererseits eine hohe Präzision bei der Fertigung. Des Weiteren werden sie in einem Stück hergestellt, vereinigen Linsen und Träger ineinander, sind leicht zu handhaben, zu transportieren und miteinander zu verbinden. Die Trennung der Linsenwafer aus den entsprechenden Prägeformen oder von den Prägestempeln stellt ein großes technisches Problem dar.

Der vorliegenden Erfindung liegt die Aufgabe zugrunde, ein Verfahren anzugeben, mit welchen, insbesondere in einem vollautomatischen Prozess, das Ablösen des Linsenwafers verbessert wird.

Diese Aufgabe wird mit den Merkmalen des Anspruchs 1 gelöst. Vorteilhafte Weiterbildungen der Erfindung sind in den Unteransprüchen angegeben. Bei angegebenen Wertebereichen sollen auch innerhalb der genannten Grenzen liegende Werte als Grenzwerte offenbart gelten und in beliebiger Kombination beanspruchbar sein.

Der Erfindung liegt der Gedanke zugrunde, vor dem Aushärten des Linsenwafers mindestens ein Entformelement zum Ablösen des ausgehärteten Linsenwafers von dem ersten und/oder dem zweiten Prägestempel zwischen dem ersten und zweiten Prägestempel anzuordnen. Durch diese erfindungsgemäße Maßnahme wird die Zeit beim Einbringen der Prägemasse zwischen den ersten und zweiten Prägestempel und/oder die Zeit beim Ausrichten des ersten und zweiten Prägestempels zueinander und/oder die Zeit beim Prägen der Prägemasse beziehungsweise beim aufeinander zu Bewegen der Prägestempel zur Positionierung/Anordnung mindestens eines Entformelementes genutzt. Hierdurch wird es erfindungsgemäß ermöglicht, unmittelbar nach dem Aushärten der Prägemasse mit dem Ablösen des Linsenwafers zu beginnen. Somit eignen sich die erfindungsgemäße Vorrichtung und das erfindungsgemäße Verfahren insbesondere für monolithische Linsenwafer.

Mit anderen Worten besteht die Erfindung darin, vor einer Urformung des erfindungsgemäßen Linsenwafers ein Werkzeug, insbesondere Entformelement, so zwischen dem oberen und dem unteren Prägestempel einzubauen, dass bei der Urformung des, insbesondere monolithischen, Linsenwafers eine formschlüssige Verbindung zwischen dem urgeformten Linsenwafer und dem Werkzeug ausgebildet wird. Mittels der formschlüssigen Verbindung ist es in besonders vorteilhafter Weise möglich, den Linsenwafer von dem unteren und/oder oberen Prägestempel abzulösen.

Die Erfindung eignet sich somit insbesondere für die Verwendung bei trägerlosen Linsenwafern.

Ein wesentlicher Vorteil der vorliegenden Erfindung besteht darin, dass die Entformung eines, insbesondere trägerlosen, Linsenwafers vom oberen und/oder unteren Prägestempel zumindest weitgehend beschädigungsfrei sowie automatisiert für massenfertigungstaugliche Produktionslösungen durchführbar ist.

Gemäß einer vorteilhaften Ausführungsform der vorliegenden Erfindung ist vorgesehen, dass das Entformelement einen Beaufschlagungsabschnitt mit einer Stirnseite aufweist, dessen Außenkontur so geformt ist, dass der Beaufschlagungsabschnitt in einem, insbesondere am Umfang des unteren und/oder oberen Stempels angeordneten, unstrukturierten Bereich außerhalb von unteren und/oder oberen Linsenformen zur Urformung der Mikrolinsen anordenbar ist. Auf diese Weise kann der für das Entformelement für das Ablösen benötigte Beaufschlagungsbereich so angeordnet werden, dass die Ausbeute an Mikrolinsen an dem Linsenwafer nicht verringert wird.

Dabei ist es besonders vorteilhaft, wenn das Entformelement an der Stirnseite zumindest im Beaufschlagungsabschnitt eine, insbesondere einheitliche, Dicke d kleiner der Prägedicke des Linsenwafers aufweist. Die Prägedicke des Linsenwafers ist insbesondere kleiner 2000 µm, vorzugsweise kleiner 1500 µm, noch bevorzugter kleiner 1000 µm, am bevorzugtesten kleiner 500 µm. Bevorzugt ist es dabei, wenn die Dicke d größer 1/5, vorzugsweise größer 1/3, vorzugsweise größer 1/2 der Prägedicke, am bevorzugtesten größer als 3/4 des Linsenwafers ist.

Soweit mindestens ein unteres Entformelement zur Anlage an einem Umfangsabschnitt des unteren Stempels und ein oberes Entformelement zur Anlage an einem, insbesondere beabstandeten, vorzugsweise gegenüberliegenden, Umfangsabschnitt aufweist, kann für das Ablösen des Linsenwafers von dem oberen und unteren Stempel jeweils mindestens ein separates Entformelement vorgesehen werden, so dass jedes Entformelement ideal gegenüber dem jeweiligen Stempel positioniert werden kann.

Folgende Verfahrensschritte sind erfindungsgemäß vorgesehen, insbesondere in der nachfolgend aufgeführten Reihenfolge:
- Aufbringen einer Prägemasse auf einen unteren Stempel oder einen Wafer (Trägerwafer für den Linsenwafer und die Mikrolinsen), insbesondere mittels einer Aufbringeinrichtung der Vorrichtung, insbesondere einer exakt steuerbaren Dispenseinrichtung,
- Anordnung mindestens eines Entformelements zwischen dem unteren und einem, insbesondere zu dem unteren Stempel ausgerichteten, oberen Stempel,
- Prägen der Prägemasse durch den oberen Stempel (also durch aufeinander zu bewegen des unteren und oberen Stempels),
- Aushärten der Prägemasse, wobei die Anordnung des Entformelements vor dem Aushärten erfolgt.

Erfindungsgemäß ist es dabei von Vorteil, wenn ein Beaufschlagungsabschnitt des Entformelements in einem unstrukturierten Bereich des oberen Stempels angeordnet wird.

Weiterhin ist es erfindungsgemäß vorteilhaft, dass der Linsenwafer nach dem Aushärten mittels des Entformelements von dem unteren und/oder oberen Stempel abgelöst wird.

Die Aushärtung erfolgt entweder thermisch und/oder durch elektromagnetische Strahlen und/oder chemisch.

Bei der thermischen Härtung ist es von Vorteil, wenn der untere und/oder der obere Stempel eine entsprechend hohe Wärmeleitfähigkeit besitzt. Die Wärmeleitfähigkeit liegt zwischen 0.01 W/(m*K) und 500 W/(m*K), mit größerem Vorzug zwischen 1 W/(m*K) und 500 W/(m*K), mit größtem Vorzug zwischen 10 W/(m*K) und 500 W/(m*K), mit allergrößtem Vorzug zwischen 100 W/(m*K) und 500 W/(m*K).

Bei der Aushärtung durch elektromagnetische Strahlung ist der obere und/oder untere Stempel transparent für alle Wellenlängen, die zu einer Aushärtung führt. Da die meisten Materialien bevorzugt durch UV Strahlung gehärtet werden, liegt der bevorzugte Transparenzbereich zwischen 10 nm und 400 nm. Die Ausführungsform mittels elektromagnetischer Strahlung stellt die erfindungsgemäß bevorzugte Ausführungsform dar.

Bei einer chemischen Aushärtung ist der obere und/oder untere Stempel so ausgeführt, dass entsprechende Chemikalien Zugang zur Prägemasse bekommen. Entweder durch poröse Stempel oder durch eigens in die Stempel eingearbeitete Mikro- und/oder Nanokanäle.

Die Entformelemente bestehen bevorzugt aus einem korrosionsbeständigen, kostengünstigen, leichten, hochfesten Material. Die Entformwerkzeuge können aus mindestens einem der nachfolgend aufgeführten Materialien bestehen:
- Metall
- Keramik
- Glas
- Graphit
- Polymer
- Verbundwerkstoffen

Des Weiteren ist es vorteilhaft, wenn die Entformelemente geringe Adhäsionseigenschaften zum Linsenmaterial besitzen. Die Entformelemente besitzen dabei entweder auf Grund ihrer materialspezifischen Eigenschaften eine geringe Adhäsion zum Linsenmaterial oder werden entsprechend mit Antihaftschichten beschichtet. Besonders für die Beschichtung geeignet sind vor allem organische Moleküle. Besonders geeignet sind fluorhaltige und/oder thiolhaltige organische Moleküle, beispielsweise Kunstoffe wie PFPE. Denkbar wäre auch die Beschichtung der Entformwerkzeuge mit speziellen Antihaftschichten, die sich in Monolagen abscheiden lassen.

Bestehen die Entformelemente aus einem thermisch sehr leitfähigen Material, ist auch die Einbringung von Wärme für ein thermischen Aushärten über die Entformelemente erfindungsgemäß denkbar.

Die Anzahl der Entformelemente pro Seite beträgt eins, mit Vorzug zwei, mit größerem Vorzug drei, mit größtem Vorzug vier, mit allergrößtem Vorzug mehr als vier. Je mehr Entformelemente verwendet werden, desto kleiner können die Beaufschlagungsabschnitte und/oder die Abstände zwischen den einzelnen, benachbarten Entformelementen sein, was sich positiv auf die Biegefestigkeit bei der Entformung auswirkt.

In einer besonderen erfindungsgemäßen Ausführungsform wechseln sich die oberen und unteren Entformelemente entlang des Umfangs ab, wobei eine zumindest teilweise Überlappung erfindungsgemäß vorgesehen sein kann.

In einer weiteren erfindungsgemäßen Ausführungsform besitzt jedes Entformelement ein entsprechendes, dem Entformelement deckungsgleiches, insbesondere fluchtend gegenüberliegendes, Entformelement auf der jeweils gegenüberliegenden Seite.

Soweit in einer erfindungsgemäßen Ausführungsform zumindest teilweise, vorzugsweise überwiegend übereinanderliegende bzw. gegenüberliegend fluchtende Entformelement vorgesehen sind, kann die Außenkontur des Linsenwafers am Rand zur Verbesserung der Stabilität und stabilen Entformung modifiziert werden. Erfindungsgemäß ist daher gemäß einer vorteilhaften Ausführungsform eine Modifikation des oberen und/oder unteren Stempels durch Entformungsvertiefungen an allen Stellen, an denen Entformungswerkzeuge eingesetzt werden sollen, vorgesehen. Dadurch wird der Linsenwafer, insbesondere ohne eine Reduktion seiner mittleren Dicke, über die Entformungswerkzeuge erweitert und kann nach dem Prägevorgang stabil entformt werden.

Außerdem ist als eigenständige Erfindung eine (insbesondere mehrere) Mikrolinse(n) anzusehen, die aus dem Linsenwafer durch Vereinzelung hergestellt ist (sind).

Als eigenständige Erfindung ist auch ein Linsenwafer anzusehen, der durch die erfindungsgemäß beschriebene Vorrichtung und/oder das erfindungsgemäß beschriebene Verfahren hergestellt ist.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische Aufsicht auf einen oberen Stempel mit einem Entformelement in einer ersten Ausführungsform gemäß Schnittlinie A-A aus Figur 1b,
- Figur 1b: eine schematische Schnittansicht der Vorrichtung in der ersten Ausführungsform gemäß Schnittlinie C-C aus Figur 1c,
- Figur 1c: eine schematische Aufsicht auf den unteren Stempel und ein Entformelement gemäß Schnittlinie B-B aus Figur 1b,
- Figur 2a: ein erster Verfahrensschritt gemäß der vorliegenden Erfindung, nämlich Anordnung eines unteren Entformelements,
- Figur 2b: ein zweiter Verfahrensschritt, nämlich Aufbringen einer Prägemasse,
- Figur 2c: ein dritter Verfahrensschritt, nämlich Anordnung eines oberen Entformelements sowie Anordnung und Ausrichtung des oberen Stempels zum unteren Stempel,
- Figur 2d: ein vierter Verfahrensschritt, nämlich Prägen der Prägemasse,
- Figur 2e: ein fünfter Verfahrensschritt, nämlich Aushärten der Prägemasse, insbesondere durch den oberen Stempel hindurch,
- Figur 2f: ein sechster Verfahrensschritt, nämlich Entformen des oberen Stempels von dem ausgehärteten Linsenwafer,
- Figur 2g: ein siebter Verfahrensschritt, nämlich Entformen des unteren Prägestempels von dem ausgehärteten Linsenwafer,
- Figur 2h: ein siebter Verfahrensschritt, nämlich Entformen des unteren Prägestempels von dem ausgehärteten Linsenwafer, mit einer zweiten Ausführungsform des Stempels,
- Figur 3a: eine schematische Darstellung einer zweiten Ausführungsform mit zwei Entformelementen,
- Figur 3b: eine schematische Darstellung einer dritten Ausführungsform mit drei Entformelementen und
- Figur 3c: eine schematische Ansicht einer vierten Ausführungsform mit vier Entformelementen.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleich wirkender Funktion mit identischen Bezugszeichen gekennzeichnet sind.

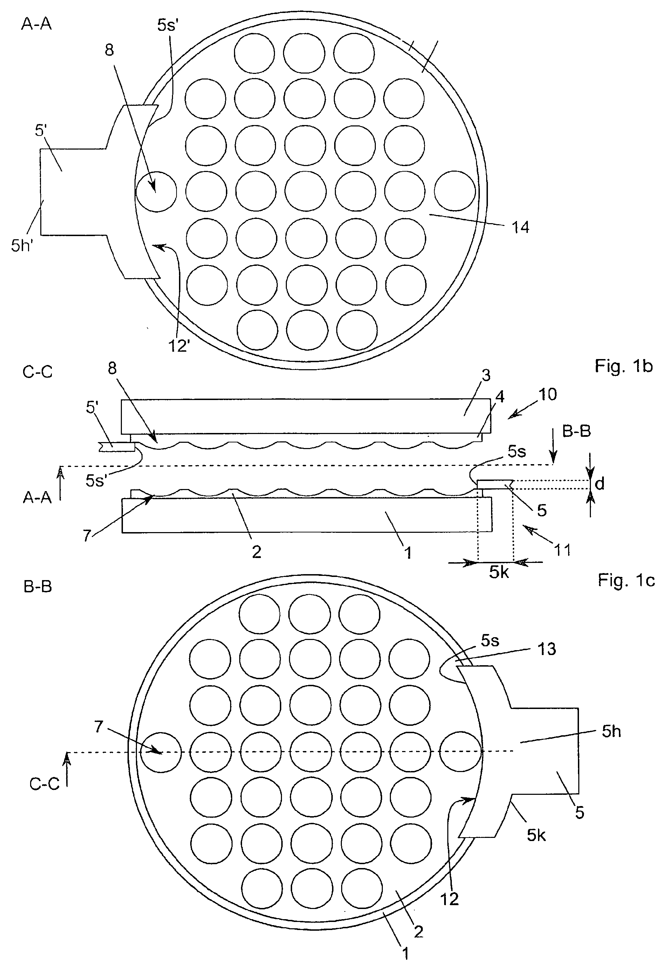

In der in Figuren 1a bis 1c gezeigten Ausführungsformen sind wesentliche Bestandteile der Vorrichtung gezeigt, während andere Bestandteile der Vorrichtung nicht dargestellt sind, da die Ausgestaltung dieser Bestandteile für den Fachmann selbstverständlich ist oder sich aus der nachfolgenden Funktionsbeschreibung eindeutig ergibt.

Demnach weist die Vorrichtung ein unteres Prägeelement 11 sowie ein oberes Prägeelement 10 und, insbesondere den jeweiligen Prägeelementen 10, 11 zugeordnete Entformelemente 5, 5' auf. Das untere Prägeelement 11 dient zur Aufnahme eines unteren Stempels 2 auf einer Halterung 1 und das obere Prägeelement 10 dient zur Aufnahme eines oberen Stempels 4 auf einer Halterung 3. Das untere Prägeelement 11 und das obere Prägeelement 10 sind relativ zueinander beweglich und es sind Mittel zur Ausrichtung des oberen und unteren Prägeelements 10, 11 vorgesehen, insbesondere gesteuert durch eine nicht dargestellte Steuerungseinrichtung. Bei den Halterungen 1 und/oder 3 kann es sich um jede beliebige Art der Fixierung für die Stempel 2 und/oder 4 handeln. In einem speziellen Fall sind die Halterungen 1 und/oder 3 sogenannte "back-planes" und die Stempel 2 und/oder 4 sind unlösbar mit ihnen verbunden.

Der untere Stempel 2 weist an seiner dem oberen Stempel 4 zugewandten Seite eine Vielzahl von unteren Linsenformen 7 zur Formung/Prägung einer Funktionsfläche (Optik) einer Vielzahl von Mikrolinsen 15 eines Linsenwafers 6 auf. Der obere Stempel 4 weist an seiner dem unteren Stempel 2 zugewandten Seite obere Linsenformen 8 zur Ausformung/Prägung einer zweiten Funktionsfläche (Optik) einer Vielzahl von Mikrolinsen 15 auf. Somit weisen der obere und der untere Stempel 2, 4 eine identische Zahl von Linsenformen 7, 8 mit korrespondierender Anordnung auf.

Der untere Stempel 2 und der obere Stempel 4 weisen somit außerhalb der unteren und/oder oberen Linsenformen 7, 8 jeweils einen unstrukturierten Bereich 13, 14 auf, die jeweils im Wesentlichen eine Ebene bilden, die zueinander parallel verlaufen.

Die, insbesondere modular austauschbar ausgebildeten, Entformelemente 5, 5' sind gegenüber den unteren und oberen Stempeln 2, 4 bewegbar und ausrichtbar. Die Entformelemente 5, 5' weisen einen Halteabschnitt 5h, 5h' und einen an dem Halteabschnitt 5h, 5h' angeformten Beaufschlagungsabschnitt 12, 12' auf, der an Stirnseiten 5s, 5s' der Entformelemente 5, 5' angeordnet ist. Die Halteabschnitte 5h, 5h' dienen der Halterung und Bewegung der Entformelemente 5, 5' durch nicht dargestellte Positioniereinrichtungen, insbesondere Roboterarme. Die Entformelemente 5, 5' können auch durch entsprechende Antriebe einzeln gesteuert werden oder bevorzugt durch einfache elektrische und/oder mechanische Maschinenelemente miteinander gekoppelt sein. Denkbar sind rein elektrische, mechanische, pneumatische oder hydraulische Antriebe, welche die Positionssteuerung übernehmen und/oder die entsprechende Kraft aufbringen, um die Entformung durchzuführen. Alle Entformelemente können über Sensoren verfügen, die mit den entsprechenden Antrieben über einen Regelkreis verbunden sind, um eine hardware- und/oder softwaregesteuerte Entformung zu ermöglichen.

Die Stirnseiten 5s, 5s' sind insbesondere so geformt, dass die Beaufschlagungsabschnitte 12, 12' die Linsenwafer 6 an deren unstrukturiertem Bereich beaufschlagend ausgebildet sind. Vorzugsweise liegt ein Entformelement 5' dem oberen Stempel 4 zugeordnet, insbesondere an dessen Umfang, im unstrukturierten Bereich 14 an. Insbesondere liegt ein weiteres, dem unteren Stempel 2 zugeordnetes Entformelement 5 an dessen Umfang im unstrukturierten Bereich 13 an.

Die Entformelemente 5, 5' weisen zumindest in den Beaufschlagungsabschnitten 12, 12' eine Dicke d auf, die kleiner als eine Prägedicke D (Abstand der ebenen unstrukturierten Bereiche 13, 14) ist.

Bevorzugt erstrecken sich die Stirnseiten 5s, 5s' über einen Umfangsabschnitt der Stempel 2, 4, vorzugsweise kleiner ¼ des Umfangs der Stempel 2, 4 ist. Insbesondere sind die Stirnseiten 5s, 5s' konzentrisch zu den Stempeln 2, 4 verlaufend ausgebildet.

Die erfindungsgemäße Funktion der Entformelemente 5, 5' besteht in der Fixierung, Stabilisierung und/oder Trennung mindestens eines geprägten, monolithischen Linsenwafers 6 vor, während und nach der Prägung/Aushärtung.

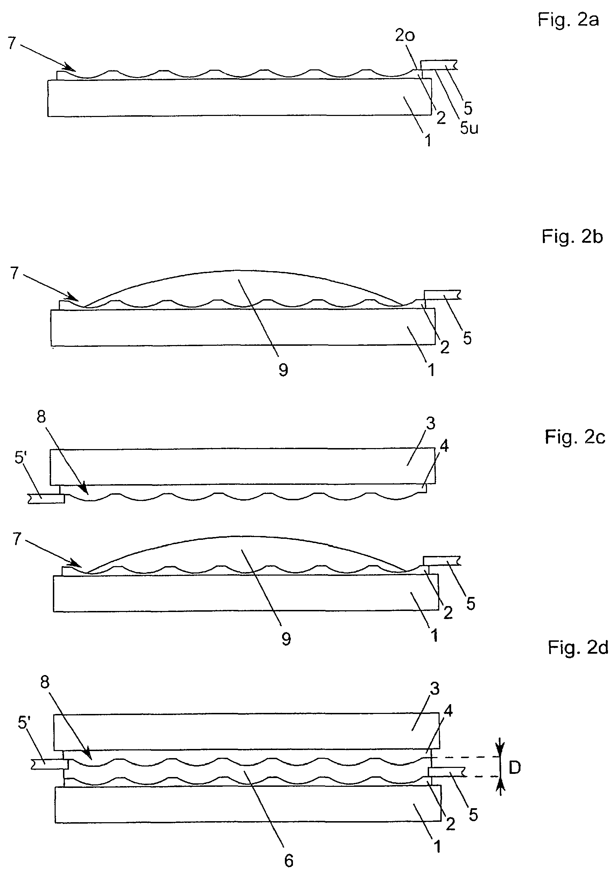

In einem ersten, in Figur 2a gezeigten Prozessschritt wird das dem unteren Stempel 2 zugeordnete Entformelement 5 mit seiner Unterseite 5u, insbesondere ausschließlich, über dem unstrukturierten Bereich 13 des unteren Stempels 2 angeordnet, insbesondere kontaktiert.

In einem weiteren, in Figur 2b gezeigten Prozessschritt wird eine nicht ausgehärtete Prägemasse 9 auf den unteren Stempel 2 aufgebracht. Die Aufbringung erfolgt durch ein nicht dargestelltes Dispensersystem.

In einem weiteren, in Figur 2c gezeigten dritten Prozessschritt wird der obere Stempel 4 positioniert. Die Positionierung der beiden Stempel 2, 4 zueinander kann durch entsprechende Ausrichtungstechniken, Alignmentsysteme oder rein mechanisch erfolgen. Vor einem Prägen der Prägemasse 9 mit dem oberen Stempel 4 (also Kontaktierung der Prägemasse 9 durch die Stempel 2, 4) wird das dem oberen Stempel 4 zugeordnete Entformelement 5' mit seiner Oberseite 5o' unter dem unstrukturierten Bereich 14 angeordnet, insbesondere kontaktiert.

In einem in Figur 2d gezeigten vierten Prozessschritt folgt eine relative Annäherung der beiden Stempel 2, 4 zueinander und somit das Prägen (Urformung des Linsenwafers 6, insbesondere einschließlich Aushärten).

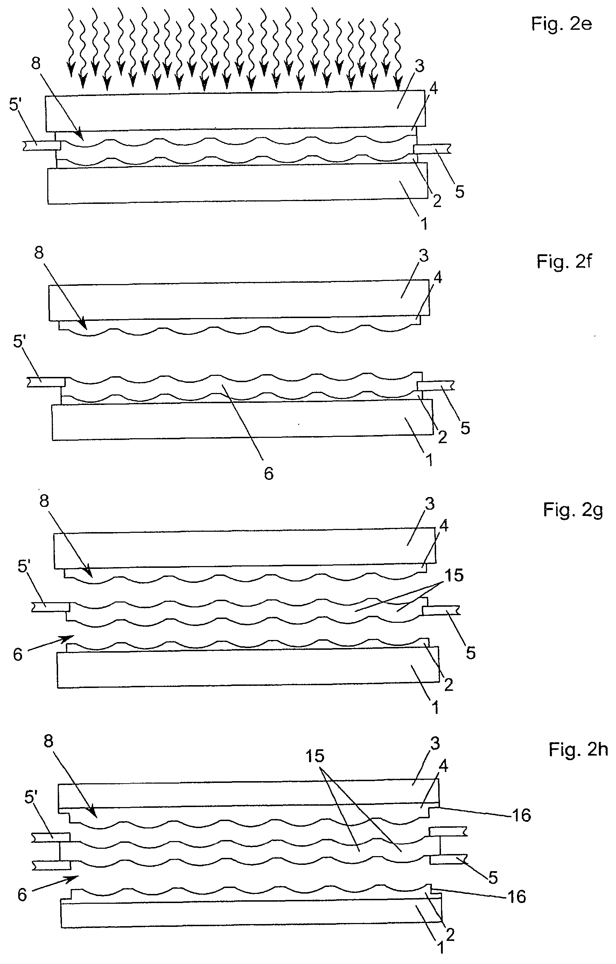

In einem weiteren, in Figur 2e dargestellten Prozessschritt wird der monolithische Linsenwafer 6 durch einen Härteprozess ausgehärtet. Die Aushärtung kann dabei durch alle bekannten Verfahren erfolgen. Chemisch, durch elektromagnetische Strahlung oder durch Wärme. Im gezeigten Fall wird durch elektromagnetische Strahlung durch den oberen Stempel 4 hindurch ausgehärtet, was die bevorzugte Ausführungsform darstellt.

In einem weiteren, in Figur 2f dargestellten Prozessschritt wird der obere Stempel 4 von dem monolithischen Linsenwafer 6 zur Entformung des Stempels von dem monolithischen Linsenwafer 6 wegbewegt, wobei mittels des dem oberen Stempel 4 zugeordneten Entformelements 5' und Beaufschlagung des Linsenwafers 6 im Bereich des Beaufschlagungsabschnitts 12' mit einer entgegen der Bewegung des oberen Stempels 4 gerichteten Kraft verhindert wird, dass der Linsenwafer 6 beim Ablösen zerstört wird. Hierdurch wird das Ablösen begünstigt.

Analog wird in einem weiteren, in Figur 2g gezeigten Prozessschritt der untere Stempel 2 von dem monolithischen Linsenwafer 6 entformt, und zwar mittels des dem unteren Stempel 2 zugeordneten Entformelements 5.

Zur Minimierung der Dicke des Linsenwafers 6 bei gleichzeitig möglichst guter Überlappung der Entformelemente 5, 5' ist es in der in Figur 2h gezeigten, bevorzugten Ausführungsform vorgesehen, dass mindestens einer der Stempel 2, 4 eine der Form der Stirnseiten 5s, 5s' der Entformelemente 5, 5' entsprechende Entformungsvertiefungen 16 aufweist. Bevorzugt weisen sowohl der obere Stempel 4 als auch der untere Stempel 2 Entformungsvertiefungen 16 für alle am Umfang verteilten Entformelemente 5, 5' auf. Auf diese Weise bleibt die Dicke des Linsenwafers 6 am Rand über den Umfang verteilt einheitlich, so dass eine Beschädigung des Linsenwafers 6 vermieden werden kann.

Die Steuerung der vorbeschriebenen Prozesse erfolgt über die, insbesondere softwaregestützte, Steuerungseinrichtung der Vorrichtung.

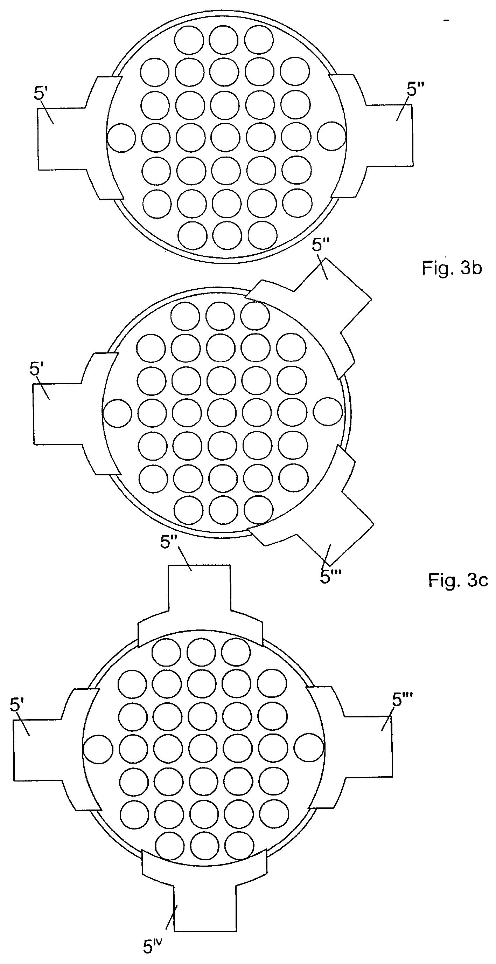

In Figuren 3a bis 3c sind weitere Ausführungsformen mit jeweils zwei, drei oder vier zueinander symmetrisch am Umfang der Stempel 2, 4 verteilt angeordneten Entformelementen 5, 5', 5", 5"' und 5^{IV} gezeigt. Vorzugsweise werden mindestens zwei Entformwerkzeuge pro Stempel 2, 4 verwendet, mit größerem Vorzug mindestens drei, mit größtem Vorzug mindestens vier, mit allergrößtem Vorzug mehr als vier.

Die Entformelemente 5, 5', 5", 5"', 5^{IV} arbeiten analog dem oben beschriebenen Entformelementen 5, 5'. Die Entformelemente 5 bis 5^{IV} sind insbesondere relativ zu den jeweils zugeordneten Halterungen 1, 3 beziehungsweise Stempel 2, 4 fixierbar.

Bevorzugt werden die die oberen Stempel 4 zugeordneten Entformelemente komplementär zu dem den unteren Stempel 2 zugeordneten Entformelementen am Umfang der Stempel 2, 4 verteilt angeordnet.

Beim Entformen ist es vorzugsweise erfindungsgemäß denkbar, die Entformelemente 5, 5', 5", 5"', 5^{IV} durch zusätzliche Stützwerkzeuge zu unterstützen und/oder am Umfang des Linsenwafers 6 verteilt im unstrukturierten Bereich des Linsenwafers 6 mittels Klemmen das Ablösen des Linsenwafers von dem unteren und/oder oberen Stempel 2, 4 zu unterstützen.

### Bezugszeichenliste

- 1: Halterung
- 2: unterer Stempel
- 3: Halterung
- 4: oberer Stempel
- 5, 5', 5", 5"', 5^{IV}: Entformelemente
- 5u: Unterseite
- 5s, 5s': Stirnseiten
- 5h, 5h': Halteabschnitte
- 6: Linsenwafer
- 7: untere Linsenformen
- 8: obere Linsenformen
- 9: Prägemasse
- 10: oberes Prägeelement
- 11: unteres Prägeelement
- 12, 12': Beaufschlagungsabschnitte
- 13: unstrukturierter Bereich
- 14: unstrukturierter Bereich
- 15: Mikrolinsen
- 16: Entformungsvertiefung
- D: Dicke
- D: Prägedicke

## Patentansprüche

1. Verfahren zur Herstellung eines Linsenwafers (6) mit einer Vielzahl von Mikrolinsen (15) mit folgenden Schritten, insbesondere folgendem Ablauf:
- Aufbringen einer Prägemasse (9) auf einen unteren Stempel (2) oder einem Wafer ,
- Anordnung mindestens eines Entformelements (5, 5', 5", 5"', 5^{IV}) zwischen dem unteren Stempel (2) und einem gegenüber dem unteren Stempel (2) ausgerichteten oberen Stempel (4),
- Prägen der Prägemasse (9) durch den oberen Stempel (4),
- Aushärten der Prägemasse (9),
**dadurch gekennzeichnet, dass** die Anordnung vor dem Aushärten erfolgt.

2. Verfahren nach Anspruch 1, bei dem ein Beaufschlagungsabschnitt (12, 12') des Entformelements (5, 5', 5", 5"', 5^{IV}) in einem unstrukturierten Bereich (14) des oberen Stempels (4) angeordnet wird.

3. Verfahren nach Anspruch 1 oder 2, bei dem der Linsenwafer (6) nach dem Aushärten mittels des Entformelements (5, 5', 5", 5"', 5^{IV}) von dem unteren Stempel (2) und/oder oberen Stempel (4) abgelöst wird.

4. Verfahren nach Anspruch 1, bei dem eine formschlüssige Verbindung zwischen dem Linsenwafer (6) und dem Entformelement (5, 5', 5", 5"', 5^{IV}) ausgebildet wird.

## Claims

1. A method for producing a lens wafer (6) with a plurality of microlenses (15) with the following steps, especially the following sequence:
- applying an embossing mass (9) to a lower die (2) or a wafer,
- placing at least one release element (5,5', 5", 5"', 5^{IV}) between the lower die (2) and an upper die (4) which is aligned relative to the lower die (2),
- embossing of the embossing mass (9) by the upper die (4),
- curing of the embossing mass (9),
**characterized in that** the placing proceeds prior to the curing.

2. The method as claimed in Claim 1, wherein one action section (12,12') of the release element (5, 5', 5", 5'", 5^{IV}) is located in an unstructured region (14) of the upper die (4).

3. The method as claimed in Claim 1 or 2, wherein the lens wafer (6) after the curing is detached from the lower die (2) and/or the upper die (4) by means of the release element (5, 5',5", 5"', 5^{IV}).

4. The method as claimed in claim 1, in which a positive connection between the lens wafer (6) and the release element (5, 5', 5", 5"', 5^{IV}) is formed.

## Revendications

1. Procédé de fabrication d'une plaquette de lentilles (6) comprenant une pluralité de microlentilles (15), comprenant les étapes suivantes, en particulier le séquencement suivant :
- application d'une matière d'empreinte (9) sur un poinçon inférieur (2) ou une plaquette,
- agencement d'au moins un élément de démoulage (5, 5', 5", 5"', 5^{iv}) entre le poinçon inférieur (2) et un poinçon supérieur (4) orienté face au poinçon inférieur (2),
- marquage de la matière d'empreinte (9) par le poinçon supérieur (4),
- durcissement par vieillissement de la matière d'empreinte (9),
**caractérisé en ce que** l'agencement a lieu avant le durcissement par vieillissement.

2. Procédé selon la revendication 1, dans lequel un segment d'insertion (12, 12') de l'élément de démoulage (5, 5', 5", 5'", 5^{iv}) est disposé dans une partie non structurée (14) du poinçon supérieur (4).

3. Procédé selon la revendication 1 ou 2, dans lequel la plaquette à lentilles (6), après durcissement par vieillissement, est séparée du poinçon inférieur (2) et/ou du poinçon supérieur (4) au moyen de l'élément de démoulage (5, 5', 5", 5"', 5^{iv}).

4. Procédé selon la revendication 1, dans lequel une liaison par complémentarité de formes est créée entre la plaquette à lentilles (6) et l'élément de démoulage (5, 5', 5", 5"', 5^{iv}).
